# EUROPEAN PATENT SPECIFICATION

(11) **EP 3 479 476 B1**
(45) Date of publication and mention of the grant of the patent: **18.08.2021**
(21) Application number: 17739780.9
(22) Date of filing: 26.06.2017
(51) Int. Cl.: H03H 9/10, H03H 3/007, B81B 7/00

(54) **COMPONENT WITH A THIN-LAYER COVERING AND METHOD FOR ITS PRODUCTION**
KOMPONENTE MIT EINER DÜNNSCHICHTIGEN ABDECKUNG UND VERFAHREN ZU DEREN HERSTELLUNG
COMPOSANT AVEC REVÊTEMENT À COUCHE MINCE ET SON PROCÉDÉ DE PRODUCTION

(30) Priority: 29.06.2016 DE 102016111911
(43) Date of publication of application: 08.05.2019
(73) Proprietor: SnapTrack, Inc., San Diego, CA 92121 (US)
(72) Inventor: ROSEZIN, Roland, San Diego, CA 92121-1714 (US); SCHAUFELE, Ansgar, San Diego, CA 92121-1714 (US)
(74) Representative: Bardehle Pagenberg Partnerschaft mbB Patentanwälte Rechtsanwälte
(86) International application number: PCT/US2017/039229
(87) International publication number: WO 2018/005337

(56) References cited:
- EP-A1- 2 327 658
- WO-A1-2014/135311
- WO-A2-2010/006065
- US-A1- 2003 155 643
- US-A1- 2012 248 580

## Description

The invention relates to a component with functional layers covered by a thin-layer covering as well as to a method for its production.

MEMS components and especially micro-acoustic components require a package, in which the functional structures of the component are protected in a mechanically secure manner and preferably encapsulated in a cavity. For producing such a package, various technologies are known, which can already be carried out at the wafer level and, therefore, allow for a cost-effective parallel processing of the components on the wafer level. It is, for example, possible to apply a wafer with component chips produced thereon onto a carrier, such as a laminate or a multilayer ceramic, in a flip chip design and to seal it against the carrier using a cover layer. It is also possible to arrange the functional structures of the component in a frame and to use this frame as a housing wall and spacer for a cover wafer.

A cost-effective method, which in addition leads to components having a small construction height, are the packages called TFP (thin film package), in which the functional structures are covered by means of a mechanically stable thin-layer design. The cavity is provided for by means of a structured sacrificial layer, which is covered together with the functional structures by the thin-layer covering, defining the cavity underneath the thin-layer covering, and being dissolved away again through structure openings in the thin-layer covering in a subsequent method step. In another step, the structure openings are sealed again.

Besides the cost advantages and the small dimensions of the TFP package, however, such components also have disadvantages. The connecting faces of a component encapsulated in this way are arranged on the chip surface, that is, between the thin-layer coverings on the surface of the carrier. In order to solder such a component to a circuit environment, e.g. a circuit board, bumps must then be used, which have a sufficient stand-off, which must have at least the height of the thin-layer covering plus a tolerance value.

It is, furthermore, disadvantageous that the technically most advantageous arrangement of the connecting faces on the carrier does not necessarily coincide with a required footprint as is customary for standardized components. In addition, a bump requires a relatively large area, which is, however, limited on the surface of the carrier, especially in the case of miniaturized components. If the distribution of the connecting faces on the carrier is adapted to a required footprint, the conductor paths required for this purpose take up additional space on the surface of the carrier, which further increases the size of the component.

WO2014/135311 A1 discloses a miniaturized component which is compatible for use with various circuit technologies. The component comprises a carrier and a functional structure on said carrier. A thin-film cover covers the functional structure and acts as a mounting base for a circuit component situated above the thin-film cover. The circuit component is connected to the functional structure by means of a lead.

US2003/0155643 A1 discloses a method of manufacturing a miniature electromechanical system (MEMS) device that includes the steps of forming a moving member on a first substrate such that a first sacrificial layer is disposed between the moving member and the substrate, encapsulating the moving member, including the first sacrificial layer, with a second sacrificial layer, coating the encapsulating second sacrificial layer with a first film formed of a material that establishes an hermetic seal with the substrate, and removing the first and second sacrificial layers.

The task of the present invention is, therefore, to specify a component with a thin-layer covering, whereby the component avoids the aforementioned disadvantages.

This task is achieved according to the invention by a component having the features of claim 1. Advantageous embodiments of the invention and a method for producing the component are to be learned from additional claims.

A component having a thin-layer covering is specified in which a first wiring layer is applied onto or over the thin-layer covering. In this way, sacrificing valuable space on the surface of the carrier for connection purposes is avoided so that the space required for this purpose is saved on the carrier.

The first wiring layer comprises structured conductor traces, which are connected to at least one connecting face on the surface of the carrier but preferably connect two or more connecting faces on the surface of the carrier to one another. The connection faces on the surface constitute the connectors of the functional structure on the carrier, such that the connection of the different connectors of the functional structure is realized in the wiring layer.

The invention has the additional advantage that it is compatible with known TFP packages and extends and improves these in terms of functionality.

In one embodiment of the invention, the first wiring layer comprises solderable connecting pads. This means that the outer connections of the functional structure are displaced to a layer above the thin-layer covering. Solderable connecting pads may be present that are displaced only from the surface of the carrier to the surface of the thin-layer covering. Additional solderable connection faces may constitute common nodes that are connected with a series of connection faces on the surface of the carrier. The solderable connecting pads over the thin-layer covering have the additional advantage that the stand-off for the joining of the AP with a circuit environment no longer needs to take into account the stand-off due to the component height. Solderable connecting pads, which constitute bus bars for a series of connecting faces, can thus reduce the number of external connectors.

The solderable connecting pads above the thin-layer covering have the additional advantage that they may be realized at nearly arbitrary horizontal positions, and thus an adaptation of the technically optimal distribution of the connection faces relative to the functional structures on the surface of the carrier may adapt to a desired pin layout or to a desired footprint for a circuit environment.

In one embodiment of the invention, the thin-layer covering comprises several partial layers. One of the partial layers is a mechanically stable layer, which can ensure the stability of the cavity enclosed thereunder at least for the next method steps. Another partial layer serves as a sealing layer for sealing the structure openings, which are conducted through the mechanically stable layer in order to dissolve away the sacrificial layer underneath the thin-layer covering. The first wiring level is preferably arranged between two partial layers of the thin-layer covering, i.e. integrated into the structure of a traditional thin-layer covering.

The invention is preferably used for components that require a cavity above their functional structures in order to function free of interference. The functional structure can, therefore, advantageously be selected from a MEMS structure, a micro-acoustic structure, a SAW structure, a BAW structure, or a GBAW structure.

A MEMS structure comprises a micro-structured 3D structure, which is preferably produced from a crystalline semiconductor body and which comprises at least one movable part, such as a membrane or a contact tab.

In the form of suitable transducer structures, a SAW structure can be applied directly on a carrier comprising a piezoelectric material.

For a BAW structure, a layer sequence is applied onto the carrier, whereby the layer sequence comprises, for example, an acoustic mirror, a first electrode above it, a piezoelectric layer, and a second electrode. The acoustic mirror comprises at least one pair of layers respectively having relatively high and relatively low acoustic impedance, which layers are formed on the one hand from a hard metal and on the other hand from a lightweight material such as SiO₂, polymer, or aluminum.

A GBAW structure comprises an electro-acoustic transducer and an acoustic waveguide layer, which can be arranged above or underneath the transducer electrodes.

As noted, the component comprises a connection face which is arranged on the carrier and is connected with both the functional structure and, via one of the structured conductor traces, with the first wiring layer.

In one embodiment, the number of the connection faces and the number of solderable connection pads may be different. In addition or alternatively, connecting faces and connecting pads may have a different distribution or a different connection pattern.

Individual solderable connecting pads may coincide, in terms of their horizontal position, with the position of connection faces on the carrier surface, but electrically are connected with a different connection face at a different location on the surface of the carrier. In this way, a consolidation of electrical connections is achieved on one plane above the carrier surface, which is especially space-saving. Furthermore, it is therefore achieved that the solderable connecting pads are produced in a desired pin layout. In other words, a physically optimal distribution of connection faces on the carrier is adapted to a desired pin layer or a wiring standard.

The first wiring layer comprises at least structured conductor traces, but may additionally also comprise circuit components connected thereto, which circuit components may likewise be present on the surface of the thin-layer covering or be integrated into the thin-layer covering. Such circuit components may be passive circuit components, for example resistance structures, capacitances or inductances, which may be comprised of correspondingly structured conductor trace segments. Such circuit components can supplement or expand the function of the component.

In a further embodiment of the invention, a second wiring layer is arranged between two partial layers of the thin-layer structure, wherein at least one electrically insulating partial layer that is arranged between the two wiring layers provides for a sufficient insulation of the two wiring layers. Both wiring layers respectively comprise structured conductor traces that, overall, may connect the layers with one another in an electrically conductive manner. In this instance, the first wiring layer preferably has no solderable connecting pads; rather, these are then arranged in the second wiring layer, since they are more easily accessible there. In exceptional cases, it may be advantageous to alternatively or additionally provide still more connecting pads in the first metallization layer.

The thin-layer covering is used for covering individual structures. The thin-layer covering used for covering entire groups of functional structures is not part of the present invention. It is crucial that the thin-layer covering still remains sufficiently mechanically stable if it spans across a relatively large area with functional structures. At least one dimension of a, for example, rectangular or approximately rectangular thin-layer covering should in this respect not exceed the limit value for sufficient mechanical stability.

A component that works with acoustic waves and that comprises transducer structures producing acoustic waves as functional structures, better electroacoustic transducers, often comprises several functional structures that are acoustically separated from one another and only connected to one another electrically. In such cases, it is advantageous to provide individual functional structures with a respective separate thin-layer covering.

Bv means of the invention, it is now possible to connect the individual functional structures to one another in a wiring layer above the thin-layer covering.

According to the invention, a component comprises a plurality of functional structures which operate with acoustic waves and are connected to form an RF filter. Each functional structure is covered by a separate thin-layer covering. The connection of the functional structures to form the RF filter is realized at least partially in the first wiring layer.

### Exemplary Embodiments and Description of the Figures

A method for producing a component according to the invention with a thin-layer covering and a wiring level is explained below with reference to the exemplary embodiments and the associated figures. The figures are used solely for a better understanding of the invention, and are, therefore, partially only schematic and not true to scale. For a better understanding, individual parts can be illustrated in an enlarged or scaled-down manner.

### BRIEF DESCRIPTION OF THE DRAWING

Figure 1A a simple example of a component in schematic cross section,
Figure 1B the same example, in plan view,
Figure 2 a second example in schematic cross section,
Figure 3 an example having two wiring layers, in schematic cross section,
Figure 4 an example having different arrangement of the wiring layer,
Figure 5 an example having a special hermetic layer,
Figures 6A to 6E different process steps in the production of a conventional thin-layer covering,
Figures 7B through G various process steps in the production of a component according to the invention,
Figures 8B through F various process steps, according to a variant, in the production of a component according to the invention,
Figures 9B through H various process steps in the production of an additional variant of a component according to the invention,
Figure 10B through F various process steps according to a last process variant.

### DETAILED DESCRIPTION

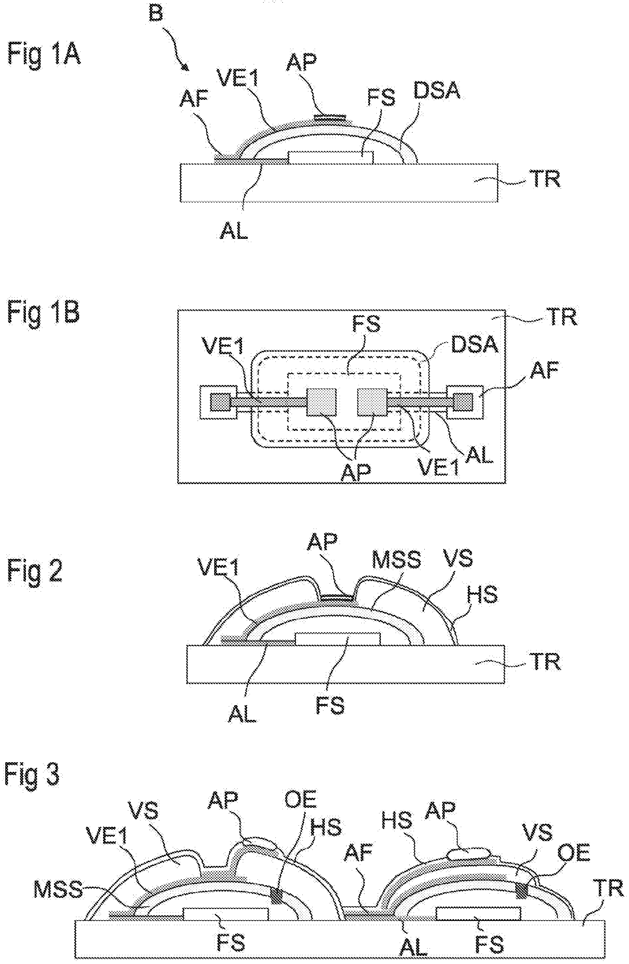

Figure 1A shows a simple example of a component using a schematic cross section drawing. Functional structures FS are arranged on a carrier TR which has at least mechanically supportive properties and possibly comprises integrated electrical components that may realize additional component function in conjunction with the functional structures. These realize the component function, or at least a portion of the component function. The functional structures FS are connected with a connection face AF by means of a connecting conductor AL.

A thin-layer covering DSA spans the functional structure FS, which is embedded in a cavity below this. The connection face AF remains free of the thin-layer covering DSA. Inasmuch, the arrangement coincides with known thin-layer coverings.

A first wiring layer VE1 is now applied on the surface of the thin-layer covering DSA or in said thin-layer covering, which first wiring layer VE1 comprises structured conductor traces that are advantageously routed to the highest point of the thin-layer covering. A connecting pad AP is then advantageously executed there, which connecting pad AP has a solderable metallization and serves for the connection of the functional structure to an external circuit environment.

Figure 1B shows the arrangement in a plan view. In contrast to Figure 1A, here two connecting conductors AL that lead to two connection faces AF are arranged directly on the substrate, pointing toward the functional structure FS. The thin-layer covering DSA spans the functional structure FS and leaves the connection faces AF free.

Structured conductor traces that form a first wiring layer VE1 are now directed on the surface of the thin-layer covering DSA. In the shown instance, each of the connection faces AF on the surface of the carrier TR is connected with a separate connecting pad AP on the top side of the thin-layer covering DSA. However, it is also possible to connect multiple connection faces AF with a common connecting pad AP, since a wiring between different connection pads AP is enabled via the first wiring layer VE1.

While the thin-layer covering DSA is depicted as a uniform material in Figure 1A, in reality it is for the most part comprised of a plurality of different partial layers to which respective different functions are accorded in the thin-layer covering DSA.

Figure 2 shows a mechanically stable layer MSS, which directly faces toward the inside of the cavity, as a lowermost and supporting partial layer of the thin-layer covering DSA. The further processing, especially the application and structuring of additional (partial) layers, is now performed on this mechanically stable layer MSS while maintaining the cavity across the functional structure ES.

In the example according to Figure 2, the metallization for the first wiring layer VE1 is applied directly onto the mechanically stable layer MSS. After the structuring of the wiring layer, a sealing layer VS serves to seal possible openings in the mechanically stable layer MSS (not depicted in the figure). Furthermore, the sealing layer VS is structured so that an area on which the solderable connecting pad AP is generated remains uncovered at the uppermost point of the first wiring layer VE1. The sealing layer VS may thereby serve as a structuring aid.

Here a hermetic layer HS that covers the entire thin-layer covering (with the exception of the connecting pads AP) is applied as a final layer which, however, is not required in all embodiments.

Figure 3 shows an additional example in schematic cross section, in which now the openings OE through which a sacrificial material below the mechanically stable layer MSS has been removed are shown in said mechanically stable layer MSS. The openings OE are sealed with the sealing layer VS, which is applied on the entire surface of the mechanically stable layer MSS.

In this example, the metallization for the first wiring layer VE1 is still to be applied and structured before the application of the sealing layer VS.

After the application and structuring of the sealing layer VS, a second wiring layer VE2 is applied and structured in the form of a metallization. This contacts the metallization of the first wiring layer VE1 in a structural gap of the sealing layer VS in which a metallization of said first metallization layer VE1 is uncovered. There, a structured conductor trace of the first wiring layer VE1 may be extended to a pad. The second wiring layer is subsequently routed to the surface of the sealing layer VS and there is provided with a solderable connecting pad AP, advantageously at the highest point. This structure is depicted in the left part of the figure.

As depicted in Figure 3, additional structure variants made up of first and second wiring layer VE1, VE2 may be realized as an alternative or in parallel to this. These differ from the variant depicted in the left figure part merely in that the connection of first and second wiring layer VE1, VE2 takes place on the surface of the carrier in the region of the connection faces AF. In the first variant, the connection of first and second wiring layer VE1, VE2 takes place at the highest point of the first wiring layer VE1.

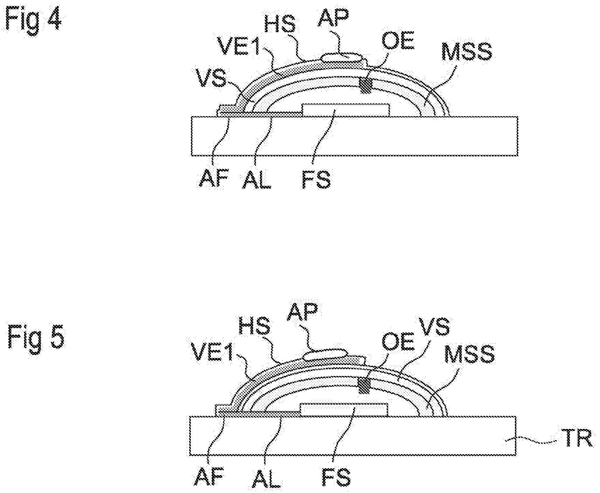

Figure 4 shows an example in schematic cross section, in which the first wiring layer VE1 is applied onto the sealing layer VS that in turn, as before, also covers the mechanically stable layer MSS. The first wiring layer VE1 in turn contacts a connection face AF on the surface of the carrier TR which is connected with the functional structure FS via a connection conductor AL. A hermetic layer HS covers the component, with the exception of the solderable connecting pad AP.

An additional possibility to integrate a wiring layer VE into the design of a thin-layer covering is depicted in figure 5. There, the sealing layer VS is covered with a hermetic layer HS that leaves uncovered only the connection face AF on the surface of the carrier TR, at least in part. In this way, the first wiring layer VE1 may now be generated over the hermetic layer HS and be electrically connected with the connection face AF.

After generation of a solderable connecting pad AP, an additional hermetic layer HS2 is generated, especially a passivation of the metallization of the first wiring layer VE1.

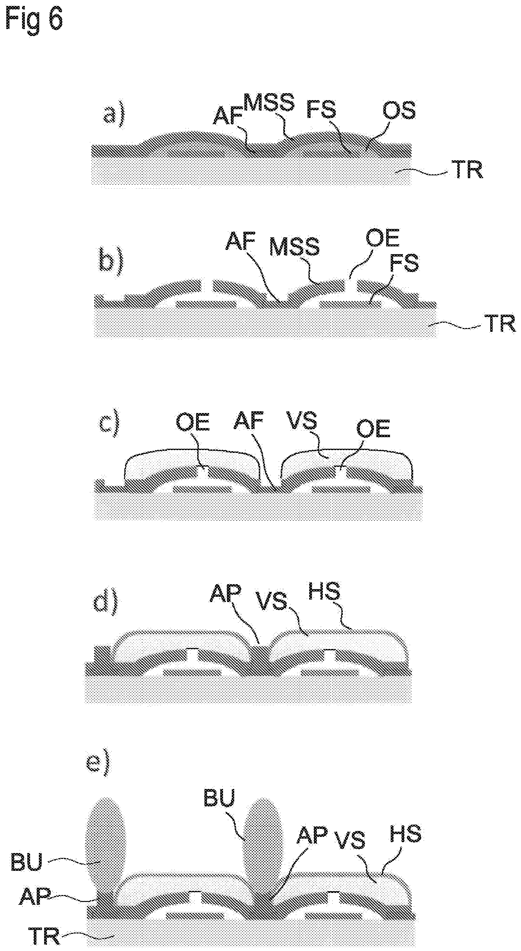

Using various schematic cross sections, Figure 6 shows various process stages of the method known per se for the production of a known component with conventional thin-layer covering. For this purpose, a functional structure FS, including supply lines and connecting faces AF, is initially produced on a carrier TR. The functional structures FS, for example, constitute transducer structures for an acoustic component, especially an SAW or BAW component.

Above the functional structures FS, a sacrificial layer OS is now applied and structured such that it defines the areas for the subsequent cavities underneath the thin-layer covering DSA. The sacrificial layer OS preferably comprises an easily structurable material, especially a lacquer layer.

A mechanically stable layer MSS is now applied onto the entire surface of the structured sacrificial layer OS; for example, an SiO₂ layer is applied by means of sputtering or CVD. Figure 1A shows the component at this method stage.

Subsequently, openings OE are produced in the mechanically stable layer MSS; through these openings, the sacrificial layer underneath the mechanically stable layer MSS can now be dissolved away. One or more openings OE can be provided for each provided cavity or for each thin-layer covering DSA. Figure 6B shows the arrangement at this method stage.

In the next step, the openings OE are sealed using a sealing layer VS. The sealing layer VS is preferably applied onto the entire surface and subsequently structured, exposing the connecting faces AF as shown in figure 6C. The cavity is thus sealed in an air-tight manner.

The sealing layer VS is preferably an organic lacquer or a polymer.

Figure 6D shows the arrangement after the production of a hermetic layer HS above the sealing layer VS as well as after the production of solderable connecting pads AP directly above the connecting faces AF on the surface of the carrier TR. The sequence for the production of the connecting pads AP and the hermetic layer HS can also be switched.

The hermetic layer HS is preferably a thick and electrically insulating layer, especially a silicon nitride layer.

Figure 6E shows the connection of such a component provided with a thin-layer covering DSA by means of bumps BU, which are produced above and in contact with the solderable connecting pads AP. The bumps U can be stud bumps or solder bumps.

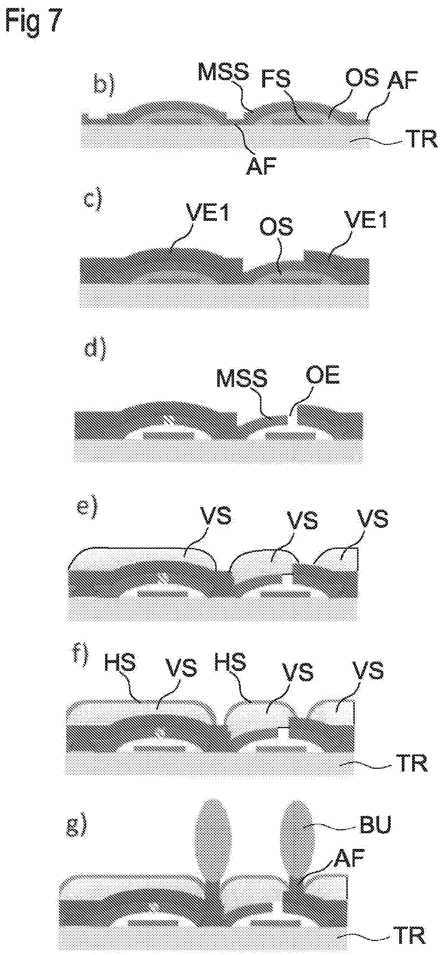

Using schematic cross sections, Figure 7 shows various process stages according to a first method variant for the manufacturing of components according to the invention. The starting point is an arrangement as depicted in figure 6A after the production of the mechanically stable layer MSS. Therefore, the presentation of this first stage is omitted in figure 7.

Figure 7B shows the arrangement after the structuring of the mechanically stable layer MSS. In particular, the connection faces AF that are electrically connected with the functional structure FS are thereby uncovered on the surface of the carrier TR.

The mechanically stable layer may be a sufficiently thick SiO₂ layer. However, the mechanically stable layer may also be multi-layer and comprise a silicon nitride layer in addition to the SiO₂ layer or as an alternative to this. However, other multi-layer embodiments are also possible insofar as they may produce a sufficient mechanical stability.

Figure 7C shows the arrangement after production and structuring of the first wiring layer VE1. This is applied as a whole-surface metallization and structured into conductor traces and the later connecting pads AP.

The metallization of the first wiring layer VE1 may be executed from a suitable metal and comprise aluminum, copper, nickel or silver. The metallization may also be multi-layer.

In the next process step, openings OE are now generated in an uncovered region of the mechanically stable layer MSS, for example via dry etching. The sacrificial layer OS is subsequently extracted through these openings OE, preferably wet-chemically with solvent or, depending on the material of the sacrificial layer OS, with an etchant.

Figure 7D shows the arrangement having an opening OE in the region of the section plane (right part of the figure), [sic] an additional opening in a region above or below the section plane, as is shown in the left half of the figure. The openings OE are preferably of small (but sufficient for extraction) cross section so that sufficient surface remains, in addition to the openings OE, to place or to structure conductor trace structures of the first wiring layer VE1 so that they are routed across the entire surface of the mechanically stable layer MSS.

In the next step, according to figure 7E a sealing layer VS is structured over the entire surface so that at least the regions for the later connecting pads AP are uncovered within the first wiring layer VE1.

The sealing layer VS is preferably applied in a liquid state, or even better a viscous state, [so] that it cannot penetrate into the openings OE. The sealing layer VS may comprise a coating in which a polymer is dissolved in a solvent. However, a liquid polymer may also be used. The polymer may be arbitrarily selected and, for example, may consist of epoxide, acrylate, polyimide or other suitable polymers or coatings, or comprise such materials.

Figure 7F shows the arrangement after the application of a hermetic layer HS that is applied over the entire surface and structured so that the region of the connecting pads AP above the first wiring layer VE1 remains free. The hermetic layer HS is preferably a silicon nitride layer, but may also comprise a different insulating material. It is also possible to generate an insulating layer from an organic or inorganic material, and to ultimately further cover this with a metallization insofar as this does not impermissibly electromagnetically interact with the functional structures.

In the next step, the solderable connecting pads AP are generated at the points at which metallizations of the first wiring layer VE1 or of the connection faces AF are free of sealing layer VS and hermetic layer HS. A solderable connecting pad AP may comprise various metals that may make the metallization of the first wiring layer VE solderable. The solderable connecting pad AP may comprise a gold layer that is advantageously applied over a nickel layer. Copper is also suitable for the generation of a solderable connecting pad AP.

Depending on the required layer thickness, various process possibilities are suitable for the application of the solderable connecting pad AP. A base metallization or a thin metal layer may be sputtered on. A thicker layer may also be generated via sputtering, or also via vapor deposition. However, it is also possible to reinforce (for example galvanically) an applied primary thin layer or an uncovered metal layer by means of metal deposition from solution. The final layer, preferably comprising gold, may be vapor-deposited.

Figure 7G shows the arrangement after the placement of bumps BU on the connecting pads AP. In any event, the first wiring layer VE1 is contacted via the bumps BU and the underlying connecting pads AP, as is depicted in the right part of the figure. Additional connecting pads AP may also be directly provided over connection faces AF in the region, as is depicted in the left part of the figure.

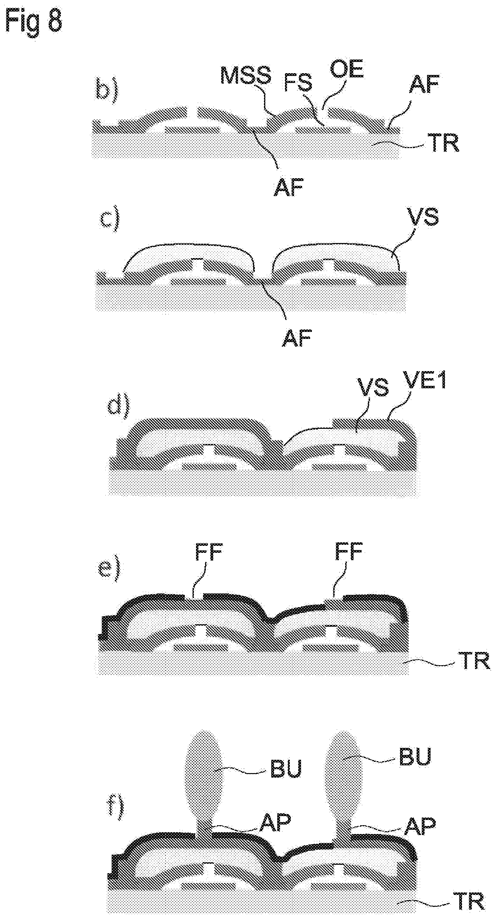

Using the process stages B through F (See Figure 6 for method stage A), figure 8 shows an additional process variant for the production of a component according to the invention with thin-layer covering and wiring layer.

Figure 8B shows the arrangement after the production of openings OE in the mechanically stable layer MSS after the extraction of the sacrificial layer, which was enclosed below said mechanically stable layer MSS. Materials for this arrangement, as well as the process steps required for this, are selected corresponding to a known thin-layer covering or the first process variant according to figure 7.

Figure 8C shows the arrangement after the application and structuring of a sealing layer VS, which may in turn take place analogously to the depiction in figure 6 or 7.

Figure 8D shows the arrangement after the application of a first wiring layer VE1 that rests on the sealing layer VS, or whose conductor traces are routed on the surface of the sealing layer VS, and therefore on the surface of the thin-layer covering DSA. The first wiring layer VE1 is connected with the connection faces AF on the surface of the carrier TR.

In the next step according to figure 8E, a hermetic layer HS is applied and structured across the entire surface of the arrangement so that only the regions of the metallization that are provided for the connecting pads AP remain clear in the first wiring layer VE1; alternatively, additional regions over the connection faces AF remain clear. These are depicted as free areas FF in the figure.

Finally, a solderable connecting pad AP is generated in the region of the free areas FF and provided with bumps BU. Figure 8F shows the arrangement at this method stage.

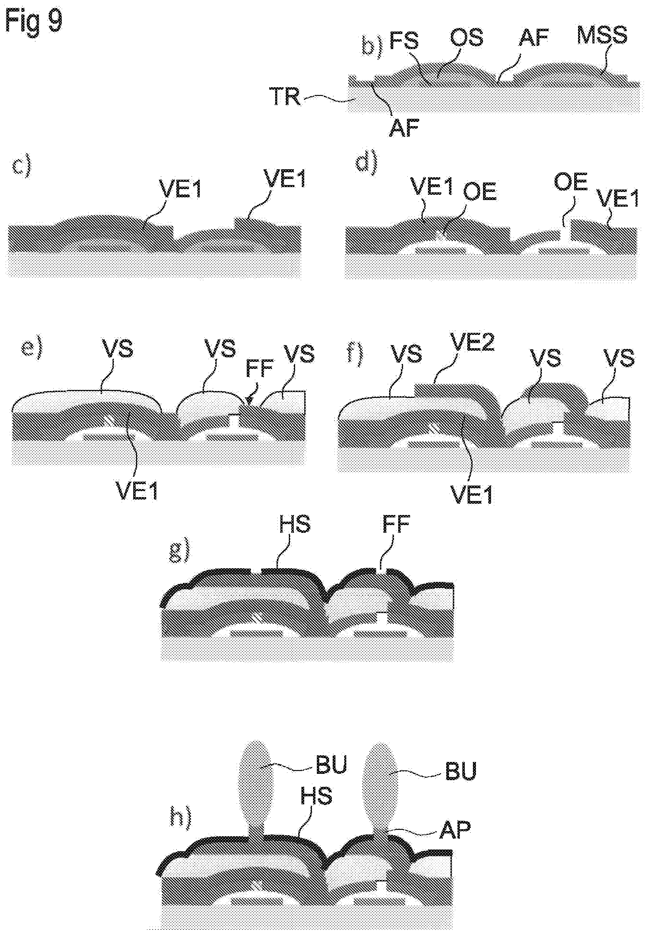

Using various process stages b through h, figure 9 shows an additional production variant of a component according to the invention having thin-layer covering. Assuming a structure according to that depicted in figure 6A, in the next step the mechanically stable layer MSS is initially structured in order to uncover the connection faces AF on the surface of the carrier TR.

In the next step, according to figure 9C a metallization for the first wiring layer VE1 is applied and structured. The structuring takes place so that a desired wiring of connection faces AF to the connecting pads is generated in the form of structured conductor traces.

A desired number of openings OE is subsequently generated in the mechanically stable layers MSS of each thin-layer covering, and the sacrificial layer is removed through these openings OE. The openings may be generated via dry etching.

If an organic coating is used as a sacrificial layer, the extraction of the sacrificial layer preferably takes place with an organic solvent. Figure 9D shows the arrangement at this method stage.

According to figure 9E, the openings OE are covered by means of a sealing layer VS that is applied over the entire surface and subsequently is structured so that free areas FF are created in which the metallization of the first wiring layer VE1 is uncovered.

As figure 9F shows, a second wiring layer VE2 in the form of a metallization is applied over the sealing layer VS and is structured to produce a desired wiring or interconnection. In the areas of the first wiring layer VE1 that are free of the sealing layer VS, the second wiring layer VE2 is engaged in electrical contact with the first.

A hermetic layer HS is subsequently deposited over the entire arrangement and structured, wherein free areas FF for the layer connecting pads remain free. Figure 9H shows the arrangement after the generation of the connecting pads AP, and the bumps that are generated on said connecting pads.

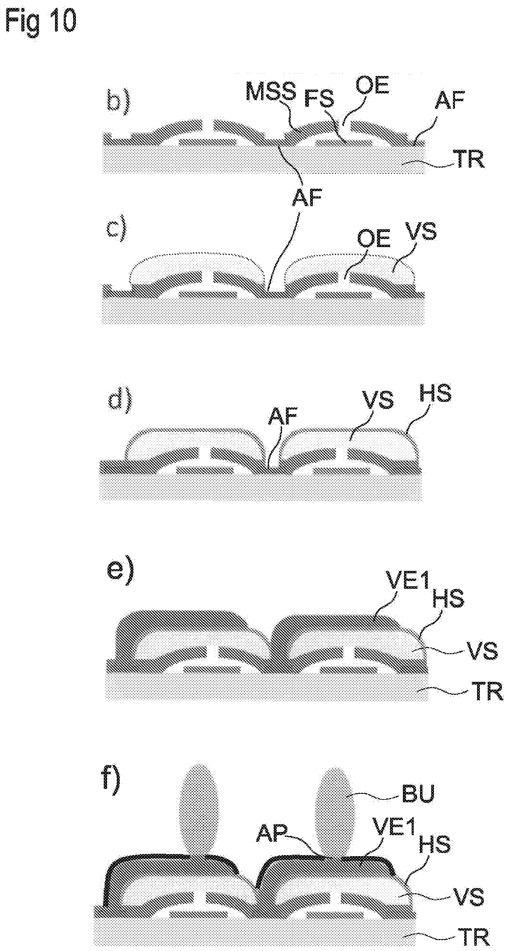

Figure 10 shows an additional process variant using process stages b through f. Starting from figure 6A, the structure depicted in figure 10B is obtained by uncovering the connection faces AF, etching of the mechanically stable layer MSS to produce openings OE, and removal of the sacrificial layer OS.

Figure 10C shows the structure after the whole-area application of a sealing layer VS and structuring via uncovering of the connection faces AF.

Figure 10D shows the arrangement after a hermetic layer HS has been applied and structured over the sealing layer VS, in that the connection faces AF have been free of the hermetic layer HS again.

A metallization is now applied and structured over the hermetic layer HS to produce the first wiring layer VE1. It thereby contacts the previously uncovered connection faces AF.

Since the sealing layer VS is already covered under the hermetic layer HS, now only the upper regions of the first wiring layer VE1 are still uncovered or unprotected. For their protection, a solderable connecting pad is initially generated on the first wiring layer. If the solderable connecting pad AP comprises a gold layer, for example, this may serve to mask the connecting pads AP from the remaining wiring layer or the remaining structures of the wiring layer if these receive an oxide passivation with the aid of an oxidation process. The gold layer, or that connecting pad AP provided with a gold layer, remains untouched by this. Figure 10F shows the arrangement after the generation of bumps BU on the solderable connecting pads AP.

The invention could be explained in reference to just a few exemplary embodiments and is, therefore, not limited to these. For the invention, it is essentially insignificant what type of structures may be encapsulated under the thin-layer covering DSA. MEMS components are preferably covered that, for interference-free operation, may not come into direct contact with a covering, and therefore require a cavity for encapsulation.

SAW and BAW modules are preferably encapsulated, as well as MEMS components. Any thin-layer covering covers individual functional structures. A thin-layer covering which covers entire groups of functional structures is not part of the present invention. The complete interconnection of the functional structures may take place within one of the wiring layers. The external contact of the component or components may be provided at the wiring layer VE1, at the wiring layer VE2, and additionally via the connection faces AF at the layer of the carrier. The connection pads AP are preferably arranged at the highest point or points of the thin-layer covering, since there the smallest stand-off is possible, thus the smallest clearance from a circuit environment into which the component is introduced via soldering.

**List of Terms and References**

| | Structured conductor paths |
|---|---|
| AF | solderable connection face (on carrier) |
| AL | connecting conductor |
| AP | connecting pad (on DSA) |
| B | Component |
| BU | bump |
| DSA | Thin-layer covering |
| FF | free area |
| FIL | RF filter |
| FS | Functional structure |
| HR | Cavity |
| HS | Hermetic layer |
| MS | Metal layer |
| MSS | Mechanically stable layer |
| OS | Sacrificial layer |
| PL | Electrically insulating layer |
| SK | Circuit components |
| TR | Carrier |
| TS | partial layer |
| UBM | Solderable metallization for solderable connecting face |
| VE1 | First wiring level |
| VE2 | Second wiring level |
| VS | Sealing layer |

## Claims

1. A component (B) comprising:
a carrier (TR);
a plurality of functional structures (FS) disposed on the carrier (TR), wherein the plurality of functional structures (FS) operates with acoustic waves and are connected to form an RF filter;
a plurality of thin-layer coverings (DSA) resting on the carrier (TR), each one of the plurality of functional structures (FS) being spanned by a separate one of the plurality of thin-layer coverings (DSA); and
a first wiring layer (VE1) disposed on each thin-layer covering (DSA) and comprising structured conductor traces, wherein the first wiring layer (VE1) is interconnected with each functional structure (FS) via the conductor traces, and connection of the plurality of functional structures (FS) to form the RF filter is realized at least partially in the first wiring layer (VE1).

2. The component (B) according to claim 1, wherein the first wiring layer (VE1) comprises solderable connecting pads (AP).

3. The component (B) according to any of claims 1-2, wherein:
the plurality of thin-layer coverings (DSA) comprises a plurality of partial layers; the plurality of partial layers comprises a mechanically stable layer (MSS) and a sealing layer (VS); the mechanically stable layer (MSS) encloses above the carrier (TR) a cavity in which at least a portion of the plurality of functional structures (FS) is enclosed; and
the first wiring layer (VE1) is arranged between two of the plurality of partial layers.

4. The component (B) according to any of claims 1-3, wherein each functional structure (FS) comprises a micro-electro-mechanical system, MEMS, structure, a micro-acoustic structure, a surface acoustic wave, SAW, structure, a bulk acoustic wave, BAW, structure, or a guided bulk acoustic wave, GBAW, structure.

5. The component (B) according to any of claims 1-4, further comprising at least one connection face (AF) disposed on the carrier (TR), wherein the at least one connection face (AF) is interconnected with at least one of the plurality of functional structures (FS) and, via one of the conductor traces, with the first wiring layer (VE1).

6. The component (B) according to claim 5, wherein at least one of:
a number of the at least one connection face (AF)is different than a number of the solderable connecting pads (AP)of the first wiring layer (VE1); or
a horizontal position of the at least one connection face (AF) is same as a horizontal position of one of the solderable connecting pads (AP).

7. The component (B) according to any of claims 1-6, further comprising one or more circuit components connected with at least one of the plurality of functional structures (FS) and disposed on the respective thin-layer covering (DSA) above the at least one of the plurality of functional structures (FS).

8. The component (B) according to any of claims 1-7, further comprising arranging a second wiring layer (VE2) between two partial layers of the plurality of thin-layer coverings (DSA), wherein: at least one electrically insulating partial layer is arranged between the first wiring layer (VE1) and the second wiring layer (VE2); the structured conductor traces from the first wiring layer (VE1) are electrically connected with structured conductor traces from the second wiring layer (VE2); and
electrical connections are provided only in upper portion of the first wiring layer (VE1) and the second wiring layer (VE2).

9. A method for producing a component (B), comprising:
arranging a plurality of functional structures (FS) on a carrier (TR);
covering each of the plurality of functional structures (FS) with a separate thin-layer covering (DSA), wherein the plurality of functional structures (FS) operates with acoustic waves;
applying a first wiring layer (VE1) on each thin-layer covering (DSA); and
structuring the first wiring layer (VE1) so that it is electrically connected with each functional structure (FS), and the plurality of functional structures (FS) are connected to form an RF filter, wherein connection of the plurality of functional structures (FS) to form the RF filter is realized at least partially in the first wiring layer (VE1).

10. The method according to claim 9, wherein applying the first wiring layer (VE1) comprises depositing a metal layer onto each thin-layer covering (DSA), the method further comprising:
applying an electrically insulating layer over the first wiring layer (VE1);
structuring the electrically insulating layer so that free areas (FF) remain; and
applying a solderable metallization onto the free areas (FF) in order to produce solderable connecting pads (AP).

## Patentansprüche

1. Bauteil (B), umfassend:
einen Träger (TR);
eine Vielzahl von Funktionsstrukturen (FS), die auf dem Träger (TR) angeordnet sind, wobei die Vielzahl von Funktionsstrukturen (FS) mit akustischen Wellen arbeitet und zum Bilden eines HF-Filters verbunden sind;
eine Vielzahl von Dünnschichtabdeckungen (DSA), die auf dem Träger (TR) ruhen, wobei jede der Vielzahl von Funktionsstrukturen (FS) von einer separaten der Vielzahl von Dünnschichtabdeckungen (DSA) überspannt wird; und
eine erste Verdrahtungsebene (VE1), die auf jeder Dünnschichtabdeckung (DSA) angeordnet ist und strukturierte Leiterbahnen umfasst, wobei die erste Verdrahtungsebene (VE1) mit jeder Funktionsstruktur (FS) über die Leiterbahnen verbunden ist und die Verbindung der Vielzahl von Funktionsstrukturen (FS) zur Bildung des HF-Filters zumindest teilweise in der ersten Verdrahtungsebene (VE1) realisiert ist.

2. Bauteil (B) nach Anspruch 1, wobei die erste Verdrahtungsebene (VE1) lötbare Anschlusspads (AP) aufweist.

3. Bauteil (B) nach einem der Ansprüche 1 bis 2, wobei:
die Vielzahl von Dünnschichtabdeckungen (DSA) eine Vielzahl von Teilschichten umfasst; die Vielzahl von Teilschichten eine mechanisch stabile Schicht (MSS) und eine Versiegelungsschicht (VS) umfasst; die mechanisch stabile Schicht (MSS) oberhalb des Trägers (TR) einen Hohlraum umschließt, in dem zumindest ein Teil der Vielzahl von Funktionsstrukturen (FS) eingeschlossen ist; und die erste Verdrahtungsebene (VE1) zwischen zwei der Vielzahl von Teilschichten angeordnet ist.

4. Bauteil (B) nach einem der Ansprüche 1 bis 3, wobei jede funktionelle Struktur (FS) eine micro-electro-mechanical system-, MEMS-, Struktur, eine mikroakustische Struktur, eine surface acoustic wave-, SAW- , Struktur, eine bulk acoustic wave-, BAW-, Struktur oder eine guided bulk acoustic wave-, GBAW-, Struktur umfasst.

5. Bauteil (B) nach einem der Ansprüche 1-4, ferner umfassend mindestens eine Verbindungsfläche (AF), die auf dem Träger (TR) angeordnet ist, wobei die mindestens eine Verbindungsfläche (AF) mit mindestens einer der Vielzahl von Funktionsstrukturen (FS) und über eine der Leiterbahnen mit der ersten Verdrahtungsebene (VE1) verbunden ist.

6. Bauteil (B) nach Anspruch 5, wobei mindestens eine von:
einer Anzahl der mindestens einen Anschlussfläche (AF) verschieden ist von einer Anzahl der lötbaren Anschlusspads (AP) der ersten Verdrahtungslage (VE1); oder
eine horizontale Position der mindestens einen Anschlussfläche (AF) gleich ist einer horizontalen Position von einem der lötbaren Anschlusspads (AP).

7. Bauteil (B) nach einem der Ansprüche 1 bis 6, ferner umfassend eines oder mehrere Bauteile, die mit mindestens einer der Vielzahl von Funktionsstrukturen (FS) verbunden sind und auf der jeweiligen Dünnschichtabdeckung (DSA) oberhalb der mindestens einen der Vielzahl Funktionsstrukturen (FS) angeordnet sind.

8. Bauteil (B) nach einem der Ansprüche 1 bis 7, ferner umfassend Anordnen einer zweiten Verdrahtungsebene (VE2) zwischen zwei Teilschichten der Vielzahl von Dünnschichtabdeckungen (DSA), wobei: zwischen der ersten Verdrahtungsebene (VE1) und der zweiten Verdrahtungsebene (VE2) mindestens eine elektrisch isolierende Teilschicht angeordnet ist; die strukturierten Leiterbahnen der ersten Verdrahtungsebene (VE1) mit strukturierten Leiterbahnen der zweiten Verdrahtungsebene (VE2) elektrisch verbunden sind; und
elektrische Verbindungen nur im oberen Bereich der ersten Verdrahtungsebene (VE1) und der zweiten Verdrahtungsebene (VE2) vorgesehen sind.

9. Verfahren zum Herstellen eines Bauteils (B), umfassend:
Anordnen einer Vielzahl von Funktionsstrukturen (FS) auf einem Träger (TR);
Abdecken jeder der Vielzahl von Funktionsstrukturen (FS) mit einer separaten Dünnschichtabdeckung (DSA), wobei die Vielzahl von Funktionsstrukturen (FS) mit akustischen Wellen arbeitet;
Aufbringen einer ersten Verdrahtungsebene (VE1) auf jede Dünnschichtabdeckung (DSA); und
Strukturieren der ersten Verdrahtungsebene (VE1), so dass sie mit jeder funktionalen Struktur (FS) elektrisch verbunden ist, und die Vielzahl von funktionalen Strukturen (FS) verbunden sind, um ein HF-Filter zu bilden, wobei die Verbindung der Vielzahl von funktionalen Strukturen (FS) zur Bildung des HF-Filters zumindest teilweise in der ersten Verdrahtungsebene (VE1) realisiert ist.

10. Verfahren nach Anspruch 9, wobei das Aufbringen der ersten Verdrahtungsebene (VE1) das Aufbringen einer Metallschicht auf jede Dünnschichtabdeckung (DSA) umfasst, das Verfahren ferner umfassend:
Aufbringen einer elektrisch isolierenden Schicht über der ersten Verdrahtungsebene (VE1);
Strukturieren der elektrisch isolierenden Schicht, so dass freie Flächen (FF) verbleiben; und
Aufbringen einer lötbaren Metallisierung auf die freien Flächen (FF), um lötbare Anschlusspads (AP) zu erzeugen.

## Revendications

1. Un composant (B) comprenant :
un support (TR) ;
une pluralité de structures fonctionnelles (FS) disposées sur le support (TR), dans lequel la pluralité de structures fonctionnelles (FS) opèrent avec des ondes acoustiques et sont connectées pour former un filtre RF ;
une pluralité de revêtements à couche mince (DSA) reposant sur le support (TR), chacune de la pluralité de structures fonctionnelles (FS) étant recouverte d'un revêtement séparé de la pluralité de revêtements à couche mince (DSA) ; et
une première couche de câblage (VE1) disposée sur chaque revêtement à couche mince (DSA) et comprenant des traces conductrices structurées, dans lequel la première couche de câblage (VE1) est interconnectée avec chaque structure fonctionnelle (FS) via les traces conductrices, et la connexion de la pluralité de structures fonctionnelles (FS), pour former le filtre RF, est réalisée au moins partiellement dans la première couche de câblage (VE1).

2. Le composant (B) selon la revendication 1, dans lequel la première couche de câblage (VE1) comprend des plots de connexion soudables (AP).

3. Le composant (B) selon l'une des revendications 1 et 2, dans lequel :
la pluralité de revêtements à couche mince (DSA) comprennent une pluralité de couches partielles ; la pluralité de couches partielles comprennent une couche mécaniquement stable (MSS) et une couche d'étanchéité (VS) ; la couche mécaniquement stable (MSS) renferme, au-dessus du support (TR), une cavité dans laquelle au moins une partie de la pluralité de structures fonctionnelles (FS) est enfermée ; et la première couche de câblage (VE1) est agencée entre deux de la pluralité de couches partielles.

4. Le composant (B) selon l'une des revendications 1 à 3, dans lequel chaque structure fonctionnelle (FS) comprend une structure à système micro-électro-mécanique, MEMS, une structure micro-acoustique, une structure à ondes acoustiques de surface, SAW, une structure à ondes acoustiques de volume, BAW ou une structure à ondes acoustiques de volume guidées, GBAW.

5. Le composant (B) selon l'une des revendications 1 à 4, comprenant en outre au moins une face de connexion (AF) disposée sur le support (TR), dans lequel l'au moins une face de connexion (AF) est interconnectée avec au moins une de la pluralité de structures fonctionnelles (FS), et via une des traces conductrices, avec la première couche de câblage (VE1).

6. Le composant (B) selon la revendication 5, dans lequel au moins l'un parmi :
un nombre de l'au moins une face de connexion (AF) est différent d'un nombre des plots de connexion soudables (AP) de la première couche de câblage (VE1) ; ou
une position horizontale de l'au moins une face de connexion (AF) est identique à une position horizontale d'un des plots de connexion soudables (AP).

7. Le composant (B) selon l'une des revendications 1 à 6, comprenant en outre un ou plusieurs composants de circuit connectés à au moins une de la pluralité de structures fonctionnelles (FS) et disposés sur le revêtement à couche mince (DSA) respectif au-dessus de l'au moins une de la pluralité de structures fonctionnelles (FS).

8. Le composant (B) selon l'une des revendications 1 à 7, comprenant en outre l'agencement d'une deuxième couche de câblage (VE2) entre deux couches partielles de la pluralité de revêtements à couche mince (DSA) , dans lequel : au moins une couche partielle électriquement isolante est agencée entre la première couche de câblage (VE1) et la deuxième couche de câblage (VE2) ; les traces conductrices structurées de la première couche de câblage (VE1) sont électriquement connectées à des traces conductrices structurées de la deuxième couche de câblage (VE2) ; et des connexions électriques ne sont prévues que dans la partie supérieure de la première couche de câblage (VE1) et de la deuxième couche de câblage (VE2).

9. Un procédé de production d'un composant (B), comprenant les étapes suivantes :
agencer une pluralité de structures fonctionnelles (FS) sur un support (TR) ;
couvrir chacune de la pluralité de structures fonctionnelles (FS) d'un revêtement à couche mince (DSA) séparé, dans lequel la pluralité de structures fonctionnelles (FS) opèrent avec des ondes acoustiques ;
appliquer une première couche de câblage (VE1) sur chaque revêtement à couche mince (DSA) ; et
structurer la première couche de câblage (VE1) de manière à ce qu'elle soit électriquement connectée à chaque structure fonctionnelle (FS), et la pluralité de structures fonctionnelles (FS) sont connectées pour former un filtre RF, dans lequel la connexion de la pluralité de structures fonctionnelles (FS), pour former le filtre RF, est réalisée au moins partiellement dans la première couche de câblage (VE1).

10. Le procédé selon la revendication 9,
dans lequel l'application de la première couche de câblage (VE1) comprend le dépôt d'une couche métallique sur chaque revêtement à couche mince (DSA), le procédé comprenant en outre les étapes suivantes :
appliquer une couche électriquement isolante sur la première couche de câblage (VE1) ;
structurer la couche électriquement isolante de manière à ce qu'il reste des zones libres (FF) ; et
appliquer une métallisation soudable sur les zones libres (FF) afin de produire des plots de connexion soudables (AP).
